# DEMANDE DE BREVET EUROPEEN

(11) **EP 4 818 748 A1**
(43) Date de publication de la demande: **07.10.2026**
(21) Numéro de dépôt: 25225823.1
(22) Date de dépôt: 19.12.2025
(51) Int. Cl.: G01S 7/4863, G01S 7/48, H10F 39/10

(54) **SYSTÈME ET PROCÉDÉ DE DÉTECTION D'UNE TACHE LUMINEUSE**

(30) Priorité: 01.04.2025 FR 2503419
(71) Demandeur: New Imaging Technologies, 91370 Verrières-le-Buisson (FR)
(72) Inventeur: SCHWEITZER-CHAPUT, Martin, 91370 VERRIERES-LE-BUISSON (FR)
(74) Mandataire: Ipsilon

(57) **Abrégé**

Procédé de détection d'une tache lumineuse (T) formée par une impulsion laser délivrée par une source laser (10) sur une surface cible (S), la surface cible étant située dans un environnement délivrant un flux lumineux sensiblement statique, ce procédé comportant :
- l'observation de la surface par au moins un capteur (30) à matrice de pixels,
- la détection de l'impulsion sur un signal de sortie d'au moins une structure anti-blooming.

## Description

### Domaine technique

La présente invention concerne la détection d'une tache lumineuse au sein d'un environnement générant un flux lumineux statique relativement grand devant celui dû à ladite tache.

### Technique antérieure

De nombreuses applications nécessitent de pouvoir visualiser à l'aide d'un capteur optique une tache lumineuse produite par une impulsion laser impactant une surface.

Les capteurs optiques SWIR avec circuit de détection (ROIC) de type CMOS du type CTIA (Capacitive Trans-Inductance Amplifier) notamment comportent une photodiode polarisée en inverse et utilisée en mode photoconducteur.

La société déposante a développé des capteurs optiques dont les pixels comportent une photodiode polarisée en direct et utilisée en mode photovoltaïque.

Des exemples de tels capteurs sont décrits dans les demandes WO2002059974A1, WO2009027449A1 et WO2010103464A1.

L'avantage de ces capteurs est de pouvoir présenter de manière intrinsèque une réponse logarithmique et de ne pas saturer devant un fort flux lumineux statique provenant de la scène observée.

Dans le noir ou dans un environnement sombre il est facile de visualiser la tache produite par une impulsion laser de courte durée sur une scène ; toutefois, dans un environnement lumineux relativement important, par exemple de jour, c'est l'inverse. En effet, le flux photonique correspondant au retour laser sur l'image est relativement faible par rapport à celui provenant de l'ensemble de la scène.

Il est également connu des demandes US6369413B1, US4760435A et US20160005785A1 d'intégrer aux capteurs une structure anti-blooming pour améliorer la qualité de capteurs devant un fort flux lumineux.

La plupart des solutions visant à la détection d'une tache laser intègrent une fonction de détection sous forme d'un résultat binaire et ne permettent pas si cela est recherché de procurer une image fidèle de la tache lumineuse dans son environnement.

### Exposé de l'invention

Il existe par conséquent un besoin pour bénéficier d'une solution technique permettant de visualiser de manière plus fidèle et directe une tache lumineuse correspondant à une impulsion laser au sein d'une scène, même lorsque le flux lumineux statique provenant de la scène est relativement important, comme en plein jour. Il existe également un besoin pour détecter l'illumination d'une scène par des impulsions laser cycliques.

### Résumé de l'invention

L'invention répond à tout ou partie de ces besoins en proposant un procédé de détection d'une tache lumineuse formée par une impulsion laser délivrée par une source laser sur une surface cible, la surface cible étant située dans un environnement délivrant un flux lumineux sensiblement statique, ce procédé comportant :
- l'observation de la surface par au moins un capteur à matrice de pixels, notamment opérant en mode photovoltaïque,
- la détection de l'impulsion sur un signal de sortie d'au moins une structure anti-blooming du capteur lorsque le capteur opère en mode photovoltaïque ou lorsque le capteur opère en mode photoconducteur sur un signal de sortie d'au moins une diode de détection intégrée au capteur et autre qu'une diode correspondant à un pixel de l'image du capteur.

La détection de l'impulsion renseigne sur l'éclairage de la surface cible par la source laser. De préférence, la source laser émet à une fréquence donnée et la détection de cette fréquence dans le signal de sortie renseigne de manière fiable sur l'éclairage de la surface cible par la source laser. Dans la suite, « fréquence de l'impulsion » désigne la fréquence de répétition des impulsions laser.

Le procédé comporte avantageusement la synchronisation de la fin de l'exposition, à un retard près, avec l'impulsion laser. Cette synchronisation peut conduire dans le cas d'un capteur opérant en mode photovoltaïque à une réponse du capteur sensiblement linéaire à l'impulsion et logarithmique vis-à-vis du flux lumineux sensiblement statique

Ainsi, on obtient une réponse du capteur sensiblement linéaire à l'impulsion et logarithmique vis-à-vis du flux lumineux sensiblement statique. Le rapport signal/bruit de la tache laser par rapport au fond lumineux est amélioré, ce qui permet une meilleure visualisation de la tache y compris dans un environnement lumineux.

Cela permet de localiser la tâche laser sur la surface cible.

Dans le cas d'un capteur opérant en mode photoconducteur, un signal de sortie utile pour la détection d'une tâche lumineuse peut être délivré par une ou plusieurs diodes de détection du capteur ayant une fonction autre que celle de constituer un pixel sur l'image. Ces diodes de détection sont par exemple intégrées par construction au capteur dans des coins d'un ou plusieurs pixels, et peuvent servir initialement à améliorer la Fonction de Transfert de Modulation (FTM) du capteur.

L'utilisation d'un capteur dédié pour détecter l'impulsion n'est pas nécessaire car l'on utilise une ou plusieurs structures anti-blooming, présentes au sein du capteur, à cet effet. De même, la réception d'un signal de synchronisation non optique n'est pas nécessaire, puisque l'on peut utiliser l'image de l'impulsion sur la surface cible comme référence pour synchroniser la fin de l'exposition.

La ou les diodes qui ne sont pas utilisées pour afficher la lumière reçue par un pixel sur l'image, et qui sont utilisées pour la détection de l'impulsion, qu'elles fassent partie d'une structure anti-blooming ou qu'elles soient intégrées au capteur et non utilisées pour cette fonction anti-blooming, peuvent permettre de remonter à la fréquence de l'impulsion laser, ce qui permet de générer cette information afin par exemple de s'en servir pour délivrer un message à l'utilisateur, et/ou de synchroniser les impulsions et le processus de lecture des pixels afin de permettre de visualiser le spot laser dans l'image à l'aide des pixels dédiés à l'imagerie.

En mode photovoltaïque, on peut commander la fin de l'exposition après une durée prédéfinie après la détection du début de l'impulsion, par exemple de l'ordre de 100 microsecondes, pour bénéficier d'un bon SNR de jour comme de nuit.

En mode photoconducteur, il est également possible d'effectuer une synchronisation, et l'on peut avoir une image de la scène de la scène et du spot en combinant deux images à deux durées d'exposition différentes. En l'absence de recherche de synchronisation, le signal de sortie fournit une information utile sur la fréquence du laser, ce qui en soi est une information utile pour certaines applications.

Par « sensiblement statique » il faut comprendre que l'intensité lumineuse ne varie pas ou varie peu (par exemple moins de +/- 10%) sur une durée *tₑₓₚ* qui est grande comparativement à la durée *d* de l'impulsion laser, avec typiquement tₑₓₚ/d>10, mieux 10², encore mieux 10³. Le flux lumineux sensiblement statique correspondant par exemple à l'éclairement de la surface cible par la lumière du jour ou une quelconque source continue.

Par « réponse sensiblement linéaire » il faut comprendre une réponse en signal proportionnelle au flux d'entrée avec un écart maximum à la linéarité inférieur à 20%.

Par « à un retard près » il faut comprendre que la fin de l'exposition est décalée temporellement de la fin de l'impulsion d'une grandeur prédéfinie, de préférence inférieure ou égale à 10µs. Un faible retard permet de mesurer l'effet de l'impulsion avant le retour du capteur à l'équilibre. Ce retard peut être nul.

Par « structure anti-blooming » il faut comprendre une structure électronique configurée pour prévenir, notamment dans le mode photovoltaïque, l'effet blooming, effet qui se produit lorsque des charges électriques excessives s'accumulent dans un pixel d'un capteur en raison d'une forte lumière, et débordent dans les pixels adjacents, créant des artefacts indésirables dans l'image. La structure anti-blooming permet de détourner ces charges excédentaires, empêchant ainsi leur propagation et préservant la qualité de l'image.

La fin de l'exposition correspond au début du processus de lecture des pixels pour la production d'une image.

La structure anti-blooming peut comporter au moins un drain anti-blooming permettant d'évacuer les excès de charges dans le pixel vers une zone du capteur conçue pour les absorber. Cette zone du capteur peut notamment être connectée à une zone de décharge ou de dissipation des charges, généralement à un potentiel de référence ou de masse ; le potentiel de référence peut notamment être choisi en fonction de la sensibilité des pixels ou de l'intensité lumineuse de la scène à observer. La valeur du potentiel de référence peut être contrôlée électroniquement. Le drain anti-blooming peut notamment être formé par au moins une diode anti-blooming.

La diode anti-blooming peut être polarisée en inverse entre un potentiel de référence pour l'évacuation des charges et connectée à un pixel. La polarisation de la diode en inverse permet à la diode de devenir passante lorsque le nombre de charges produites dans le pixel dépasse une valeur seuil, et d'évacuer l'excès de charge.

La structure anti-blooming peut comporter plusieurs drains anti-blooming connectés en parallèle. Les drains anti-blooming peuvent être situés entre des pixels de la matrice de pixels du capteur, de préférence aux coins des pixels de sous-ensembles de pixels du capteur. Les drains peuvent être situés à chaque coin de chaque sous-ensemble de pixels de la matrice de pixels du capteur.

Les charges évacuées par la structure anti-blooming peuvent être converties en signal utilisé pour la détection de l'impulsion.

La structure anti-blooming utilisée pour la détection peut comporter un ou plusieurs sous-ensembles de drains d'anti-blooming disposés autour d'un ou plusieurs sous-ensembles respectifs de pixels de la matrice. Le ou les sous-ensembles de drains anti-blooming peuvent être connectés à un circuit commun de détection de l'impulsion. En variante, le ou les sous-ensembles de drains anti-blooming peuvent être connectés à un ou plusieurs circuits de détections différents.

Les sous-ensembles de drains anti-blooming peuvent être reliés ensemble, comportant des drains anti-blooming disposés selon des polygones, notamment des carrés, autour de sous-ensembles correspondants de la matrice de pixels.

La taille des sous-ensembles de pixels peut être plus ou moins grande.

La taille des sous-ensembles de pixels est par exemple comprise entre 10*10 et 50*50 pixels, mieux entre 15*15 et 35*35, étant notamment de 20*20 ou 30*30 pixels, ces plages de valeurs n'étant nullement limitatives.

Le signal de sortie de la ou de chaque structure anti-blooming utilisée pour la détection de l'impulsion peut être filtré pour diminuer le bruit. Ceci permet d'améliorer la netteté du signal de sortie de la ou de chaque structure anti-blooming pour améliorer la détection de la ou des impulsions.

Le signal de sortie de la ou de chaque structure anti-blooming utilisée pour la détection de l'impulsion peut être filtré en fréquence pour détecter la présence d'une impulsion d'une fréquence d'intérêt, notamment le front montant d'une telle impulsion. Le filtre en fréquence peut être utilisé notamment lorsque plusieurs impulsions sont reçues par le capteur pour sélectionner l'impulsion ayant la fréquence d'intérêt.

Au moins deux structures anti-blooming peuvent être utilisées respectivement pour la détection d'impulsions de fréquences différentes lorsque le capteur opère en mode photovoltaïque, ou au moins deux diodes de détection intégrées au capteur lorsque le capteur opère en mode photoconducteur, les signaux en sortie de ces structures anti-blooming ou de ces diodes pouvant être filtrés en fréquence pour détecter les impulsions auxdites fréquences, notamment leur front montant.

Au moins une partie du traitement du signal de sortie peut être effectuée au sein du capteur, notamment le signal peut être filtré pour diminuer le bruit et/ou filtré en fréquence pour détecter la présence d'une impulsion d'une fréquence d'intérêt.

Au moins une partie du traitement peut être effectué localement au sein du capteur, notamment sur la matrice de pixel à l'emplacement prévu pour au moins un pixel de la matrice.

Le traitement du signal de sortie pour chaque sous-ensemble peut être effectué localement dans le ROIC (Read Out Integrated Circuit) à l'emplacement prévu pour au moins un pixel du sous-ensemble. L'emplacement prévu pour au moins un pixel de la matrice utilisé pour le traitement du signal de sortie de chaque sous-ensemble peut être différent pour chaque sous-ensemble, ce qui diminue le risque d'artéfacts de vision pour le capteur.

En variante, l'emplacement prévu pour au moins un pixel de la matrice utilisé pour le traitement du signal de sortie de chaque sous-ensemble peut être identique pour chaque sous-ensemble, permettant de simplifier la fabrication du capteur.

Le signal de sortie peut être délivré localement sur la matrice à l'emplacement prévu pour au moins un pixel de la matrice.

La durée de l'impulsion laser est par exemple inférieure ou égale à 100ns, mieux comprise entre 5 et 30ns.

La durée d'exposition en l'absence d'impulsion laser peut être supérieure ou égale à 100 µs, notamment comprise entre 100 µs et 30ms. Cette durée peut être choisie en fonction par exemple de l'ouverture de l'optique ou si la scène observée est fortement réfléchissante. Un des avantages de l'invention est que la durée influe relativement peu ou pas sur la performance.

La fréquence de répétition des impulsions peut être déterminée sur le signal de sortie d'au moins une structure anti-blooming entre deux impulsions détectées, à partir de la mesure de l'intervalle de temps séparant deux impulsions successives. De préférence, la durée d'exposition du capteur est sensiblement constante. Pour synchroniser la fin de l'exposition avec une impulsion et disposer d'une durée d'exposition constante, le début de l'exposition est de préférence déclenché pour que la fin de l'exposition intervienne suffisamment peu de temps après chaque impulsion pour pouvoir mesurer l'impact de l'impulsion sur le capteur. Ainsi, le début de l'exposition du capteur peut être anticipé pour synchroniser la fin de l'exposition avec l'impulsion laser en fonction de la fréquence d'impulsion déterminée sur le signal de sortie de la structure anti-blooming.

Le procédé peut trouver diverses applications, parmi lesquelles, de façon non exhaustive, on peut citer l'alignement entre un émetteur et un récepteur en champ libre, l'alignement d'un émetteur avec une cible quelconque, l'analyse de la distribution d'énergie ou d'un front d'onde d'un rayonnement laser, ou le positionnement d'un rayon laser sur une surface sur laquelle doit être réalisée une soudure avec le laser. On peut encore utiliser l'image de la tache lumineuse sur une scène, fournie avec le procédé selon l'invention pour effectuer un guidage, par exemple d'un outil ou d'un objet, tel qu'un colis, vers un objectif désigné par cette tâche, par exemple en vue du largage d'un colis par un drone.

L'invention a encore pour objet, selon un autre de ses aspects, un système de détection d'une tâche lumineuse formée par une impulsion laser d'une source laser sur une scène délivrant un flux sensiblement statique, notamment pour la mise en œuvre du procédé selon l'invention tel que défini plus haut, comportant
- au moins un capteur à matrice de pixels, opérant en mode photovoltaïque ou en mode photoconducteur,
- au moins une structure anti-blooming lorsque le capteur opère en mode photovoltaïque ou, lorsque le capteur opère en mode photoconducteur, au moins une diode de détection intégrée au capteur et autre qu'une diode correspondant à un pixel de l'image,
- au moins un circuit de détection de l'impulsion sur un signal de sortie de la structure anti-blooming du capteur lorsque le capteur opère en mode photovoltaïque ou lorsque le capteur opère en mode photoconducteur sur un signal de sortie de ladite au moins une diode de détection du capteur, notamment de détection d'impulsions se répétant à une fréquence donnée,
- de préférence, un circuit de synchronisation de la fin de l'exposition du capteur, à un retard près, avec l'impulsion laser, sur la base dudit signal de sortie, cette synchronisation conduisant dans le cas d'un capteur opérant en mode photovoltaïque à une réponse du capteur sensiblement linéaire à l'impulsion et logarithmique vis-à-vis du flux lumineux sensiblement statique, et/ou un circuit de traitement pour délivrer une information relative à la fréquence de l'impulsions laser.

Le système peut comporter un filtre pour diminuer le bruit du signal de sortie de la structure anti-blooming.

Le système peut comporter un filtre en fréquence configuré pour la présence d'une impulsion d'une fréquence d'intérêt provenant du signal de sortie de la structure anti-blooming ou de ladite au moins une diode de détection intégrée au capteur, notamment le front montant d'une telle impulsion. Ce système peut comporter tout ou partie des caractéristiques précédemment mentionnées au regard du procédé.

La durée d'exposition en l'absence d'impulsion laser est comprise par exemple entre 100
µs et 30ms.

### Brève description des dessins

L'invention pourra être mieux comprise à la lecture de la description détaillée qui va suivre, d'exemples de mise en œuvre non limitatifs de celle-ci, et à l'examen du dessin annexé, sur lequel :
[Fig 1] représente de manière schématique un exemple d'ensemble selon l'invention,
[Fig 2] représente une vue schématique d'un capteur selon l'invention,
[Fig 3] représente de manière schématique un exemple d'architecture de pixel d'un capteur selon l'invention,
[Fig 4] est une vue schématique d'un capteur selon l'invention,
[Fig 5] illustre, par analogie avec le remplissage d'un réservoir, le comportement d'un pixel à réponse logarithmique face à un flux de lumière incident,
[Fig 6] illustre la réponse du pixel en fonction de la durée d'exposition,
[Fig 7] est une vue analogue à la figure 4 illustrant l'effet d'une impulsion lumineuse,
[Fig 8] représente la réponse du pixel à l'impulsion lumineuse,
[Fig 9] illustre la réduction de la durée d'exposition après détection de la fin de l'impulsion,
[Fig 10] représente la décroissance du signal du pixel après la fin de l'impulsion,
[Fig 11] illustre le signal vu par les pixels en présence et en l'absence de l'illumination laser,
[Fig 12] représente l'image de la tache après soustraction du signal correspondant au flux statique de la scène.
[Fig 13] illustre de façon schématique un exemple de chronogramme des signaux lors du fonctionnement du capteur selon un exemple de mise en œuvre de l'invention.
[Fig 14] illustre de façon schématique un exemple de pixel opérant en mode photoconducteur.

### Description détaillée

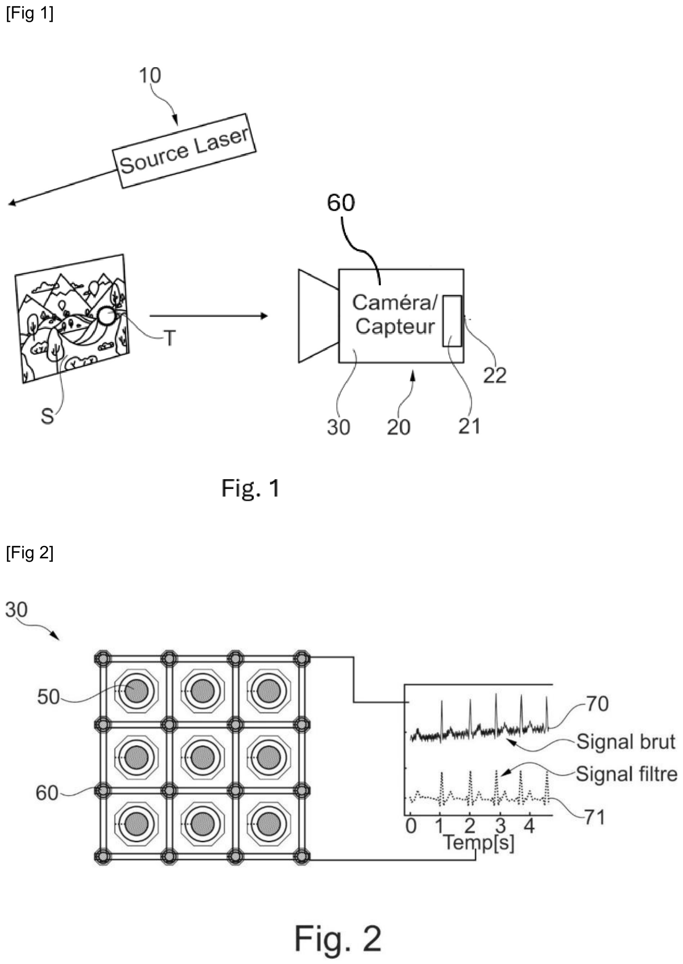

On a illustré à la figure 1 un exemple d'ensemble 1 selon l'invention, comportant une source laser 10 et un système de détection 20 permettant d'imager une scène S sur laquelle la tache T projetée par la source laser 10 est présente.

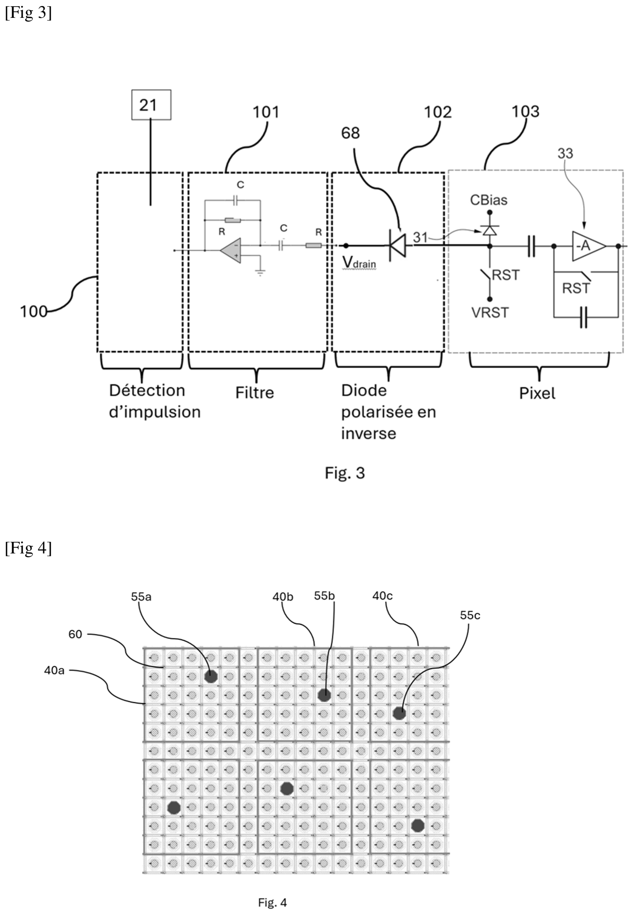

Le système de détection 20 comporte un capteur optique 30 qui comporte des pixels de préférence à réponse logarithmique, par exemple tels que celui représenté schématiquement et partiellement sur la figure 3, mais pouvant en variante être des pixels opérant de manière conventionnelle en mode photoconducteur.

Le capteur 30 comporte une structure anti-blooming 60 connectée à un circuit de synchronisation 21 du système de détection 20 qui pilote l'instant de lecture des pixels du capteur 30.

La source laser 10 peut émettre dans toute plage de longueur d'onde compatible avec sa visualisation par le système de détection, par exemple dans le domaine visible ou non, notamment dans l'infrarouge, en particulier dans la bande SWIR allant de 900 nm à 2500 nm.

La source émet des impulsions laser dont la durée est de préférence inférieure ou égale à 30ns, mieux comprise entre 1 et 30ns, notamment entre 10 et 20 ns.

La source peut comporter tout type de laser, par exemple à solide ou à gaz.

La source peut émettre les impulsions à une fréquence prédéfinie donnée.

La figure 2 représente schématiquement quelques pixels d'un exemple de capteur 30 selon l'invention, comportant une matrice de pixels, les pixels 50 étant connectés à des drains anti-blooming 60 situés aux coins de chaque pixel 50. Les drains anti-blooming sont de préférence formés par des diodes anti-blooming 68.

Les diodes anti-blooming 68 de la matrice de pixels 50 sont dans cet exemple connectées en parallèle.

Un exemple de signal brut 70 de sortie provenant des diodes anti-blooming 68 a été représenté. Le signal brut peut être filtré 71 pour réduire le bruit ou dans le cas de plusieurs impulsions ayant des fréquences différentes, être filtré en fréquence pour sélectionner l'impulsion avec une fréquence d'intérêt, à savoir celle de répétition des impulsions laser.

Un circuit de détection d'impulsion non représenté sur cette figure permet de détecter la ou les impulsions d'intérêt, notamment leur front montant, et de synchroniser (à un retard près) la fin de l'exposition du capteur avec la détection de l'impulsion afin d'obtenir la réponse sensiblement linéaire à l'impulsion et logarithmique vis-à-vis du flux lumineux, dans le cas de pixels opérant en mode photovoltaïque.

La figure 3 représente de façon schématique un exemple d'architecture de pixel d'un capteur selon l'invention. Le bloc 103 correspond à la détection et utilise une photodiode 31 polarisée en direct, de façon connue en soi qui convertit les photons reçus du flux lumineux et de l'impulsion en charges.

Le bloc 102 correspond au drain anti-blooming, et dans cet exemple comprend une diode polarisée en inverse 68 qui est connectée au pixel. A cette diode anti-blooming 68 est appliqué un potentiel de référence Vdrain. La diode polarisée en inverse 68 est bloquante vers le potentiel de référence Vdrain lorsque le nombre de charges générées dans le pixel est inférieure à un seuil et devient passante vers le potentiel de référence Vdrain lorsque le nombre de charges générées dans le pixel excède ce même seuil.

Dans un exemple de mise en œuvre du procédé, le courant en sortie de la diode polarisée en inverse 68 est converti en tension puis est filtré. Le bloc 101 correspond au filtre appliqué au signal de sortie du drain anti-blooming. Sur ce schéma le filtre est un filtre actif passe bande mais il pourrait en être autrement. À la suite de ce premier filtre pour diminuer le bruit du signal, un second filtre permettant de sélectionner une fréquence d'intérêt peut être appliqué, notamment dans le cas de plusieurs impulsions ayant des fréquences différentes. Le signal filtré est ensuite envoyé vers un circuit de détection d'impulsion au bloc 100. Lorsqu'une impulsion est détectée sur le signal issu du filtre, la fin de l'exposition du pixel est synchronisée au moyen du circuit de synchronisation de la fin de l'exposition 21.

Cette architecture de pixel a pour intérêt de ne pas saturer devant un fort flux en comprimant le flux « statique » provenant de la scène. En revanche, cette structure présente l'intérêt de répondre linéairement à une réponse impulsionnelle, avant de voir la réponse revenir progressivement à la réponse compressée du flux statique.

La figure 4 représente un exemple de capteur 30 selon l'invention, comportant des sous-ensembles de pixels 50 entourés de sous-ensembles de drains anti-blooming 40a, 40b, 40c. Dans cet exemple au moins une partie du traitement du signal de sortie des sous-ensembles de drains anti-blooming 40a, 40b, 40c est effectuée à l'emplacement 55a, 55b ou 55c prévu pour un pixel. En variante, ce traitement peut être externe au capteur.

Dans un exemple de capteur 30, les emplacements 55a, 55b ou 55c peuvent collecter les signaux de sortie des sous-ensembles de diodes anti-blooming 40a, 40b, 40c respectivement. Sur chaque emplacement 55a, 55b, 55c, un filtre anti-bruit peut être appliqué à chaque signal reçu et/ou filtré en fréquence.

Sur cet exemple, les emplacements 55a, 55b et 55c sont différents d'un sous-ensemble de pixel à un autre, mais dans une variante les emplacements 55a, 55b, 55c sont identiques dans les sous-ensembles de pixels.

L'intérêt du capteur logarithmique est alors exploité pour que la fin de la période d'exposition coïncide, avec un retard prédéfini, par exemple de l'ordre de 1µs ou moins, avec la fin de l'impulsion sur l'image, telle que détectée au moyen de la structure anti-blooming.

Ainsi, avec un temps d'exposition plus long, par exemple de l'ordre de 5 à 20ms, le signal de la scène est comprimé, mais le signal du laser ne l'est pas, ce qui permet d'avoir un rapport signal à bruit de la tâche laser par rapport au fond qui est relativement élevé, comme on va l'expliquer ci-après.

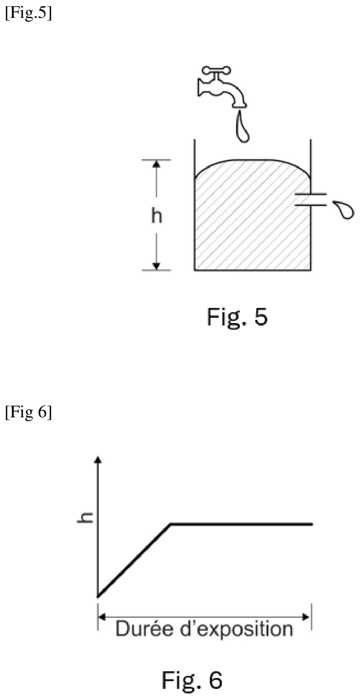

L'accumulation de charges liées à la lumière incidente au sein d'un pixel du capteur est d'une certaine manière analogue au remplissage d'un réservoir avec de l'eau, comme illustré sur la figure 5.

Pour avoir l'analogie avec un pixel dont la réponse logarithmique repose sur l'utilisation d'une photodiode en mode photovoltaïque, c'est-à-dire que l'accumulation des charges évolue de façon logarithmique passé un seuil donné, on peut considérer que le réservoir dispose d'une ouverture latérale d'évacuation de trop plein, créant une fuite à une hauteur assez basse, correspondant audit seuil. Cette ouverture latérale d'évacuation représente par analogie la structure anti-blooming.

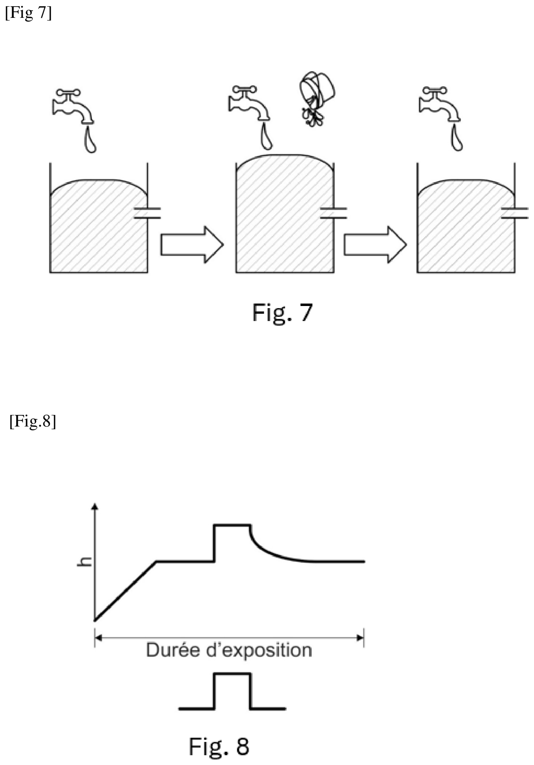

Le robinet correspond sur la figure 5 au flux de photons, qui est considéré comme étant constant pour une durée d'exposition donnée. Le niveau d'eau atteint une certaine hauteur h dans le réservoir, qui dépend du débit d'eau s'écoulant du robinet. Ce niveau ne change plus après un certain temps, comme illustré sur la figure 6, en raison de la présence du trop plein. L'effet de l'impulsion laser peut être vu comme le déversement d'un seau d'eau dans le réservoir, comme illustré à la figure 7. Ce déversement entraîne une augmentation momentanée du niveau dans le réservoir, avant que l'eau ne s'écoule par l'ouverture latérale pour revenir au niveau précédant le déversement du seau, comme illustré sur la figure 8.

Plus l'environnement lumineux est élevé, plus le flux de photons est grand, et par analogie plus la quantité apportée par le seau est faible comparativement à celle apportée par le robinet pendant la période de mesure (correspondant par analogie à la durée d'exposition).

Avec un capteur à pixel conventionnel du type CTIA, le réservoir ne dispose pas du trop plein et l'on mesure la quantité totale d'eau à la fin de la période de mesure. Si le robinet est de débit élevé, le volume du sceau reste faible par rapport à la quantité totale d'eau accumulée. Autrement dit, les charges liées à l'impulsion laser sont faibles par rapport à la quantité de charges totale accumulée. De plus, il n'est pas possible d'attendre trop longtemps l'arrivée de l'impulsion, car le réservoir continue à se remplir, en l'absence d'ouverture d'évacuation latérale.

Avec un capteur logarithmique dont le pixel opère en mode cellule photovoltaïque, on mesure la tension à la fin de la période d'exposition, soit par analogie le niveau dans le réservoir, pas la quantité totale d'eau accumulée.

Dans un pixel ce type, les charges sont vidées au début de l'exposition, en actionnant le transistor de court-circuit, puis à la fin de l'exposition, on mesure la tension, soit par analogie le réservoir est vide au début de l'exposition, et à la fin de l'exposition, on mesure la hauteur dans le réservoir.

Les pixels à réponse logarithmique peuvent être exposés à la scène à observer longtemps en avance, puisqu'ils ne craignent pas la saturation. Ainsi, dans un pixel logarithmique, le moment de la fin de l'exposition ne fait pas de différence en présence d'un flux constant de photons, mais en cas d'apport momentané, le niveau croit avant de revenir au niveau d'équilibre. On exploite cette croissance momentanée pour effectuer la mesure. On voit sur la figure 8 que si l'exposition se poursuit trop longtemps après la fin de l'impulsion, le pixel a le temps de retourner à son niveau d'équilibre.

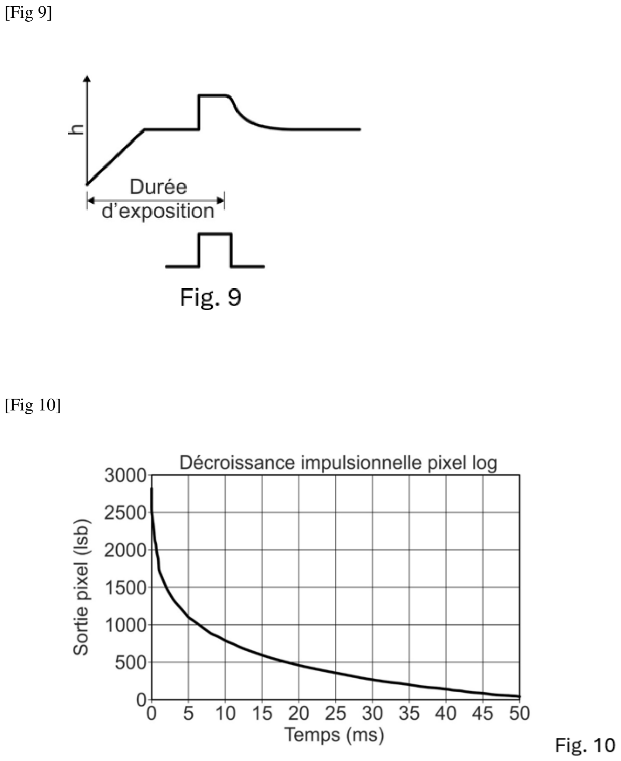

Conformément à des exemples de mise en œuvre de l'invention, on effectue la lecture du pixel, i.e. on met fin à l'exposition, suffisamment tôt après la fin de l'impulsion pour que le pixel n'ait pas eu le temps de retourner à son état d'équilibre, comme illustré sur la figure 9. La détection de l'impulsion est réalisée sur le signal de sortie de la structure anti-blooming. Dans ce cas, la tension lue inclut bien l'accroissement lié à l'impulsion, et l'on améliore le rapport signal sur bruit.

Comme illustré sur la figure 10, pour un exemple typique de pixel à réponse logarithmique, la décroissance est significative à compter de 100µs.

La lecture du pixel s'effectuera donc, de préférence, avec un retard de moins de 100µs après la fin de l'impulsion. Le début de la période d'exposition peut avoir lieu bien avant l'arrivée de l'impulsion laser, sans crainte de manquer celle-ci. Peu importe le début de la durée d'exposition, le pixel n'est pas saturé. Ceci n'est pas possible avec un pixel standard du type CTIA, qui est complètement saturé si la durée d'exposition devient trop longue.

Un autre aspect intéressant du comportement du pixel à réponse logarithmique, est que la réponse face à une impulsion n'est pas symétrique, c'est-à-dire que la croissance est très rapide tandis que la décroissance s'effectue plus lentement. Cela entraîne que le pixel va généralement avoir une augmentation complète de son signal de sortie presqu'instantanément à l'arrivée de l'impulsion, et aura une décroissance suffisamment lente pour permettre la mesure.

L'invention permet de visualiser la tache liée à l'impulsion laser et la scène ayant reçue l'impulsion sur la même image, et l'image de la tâche n'est pas une représentation binaire de celle-ci mais une image comportant l'information sur l'intensité lumineuse en chaque pixel de la tâche, liée notamment à la distribution de l'énergie lumineuse au sein du faisceau laser.

L'invention peut permettre également d'éviter les problèmes d'efficacité de remise à zéro des photodiodes rencontrées avec les capteurs de type CTIA dans certaines situations.

La vitesse de décroissance sur la figure 10 peut être ajustée en jouant sur la polarisation de la photodiode, qui permet d'optimiser le taux de décroissance et d'améliorer la réponse. La vitesse de décroissance pourra être ajustée en fonction du temps de réponse à l'impulsion nécessaire.

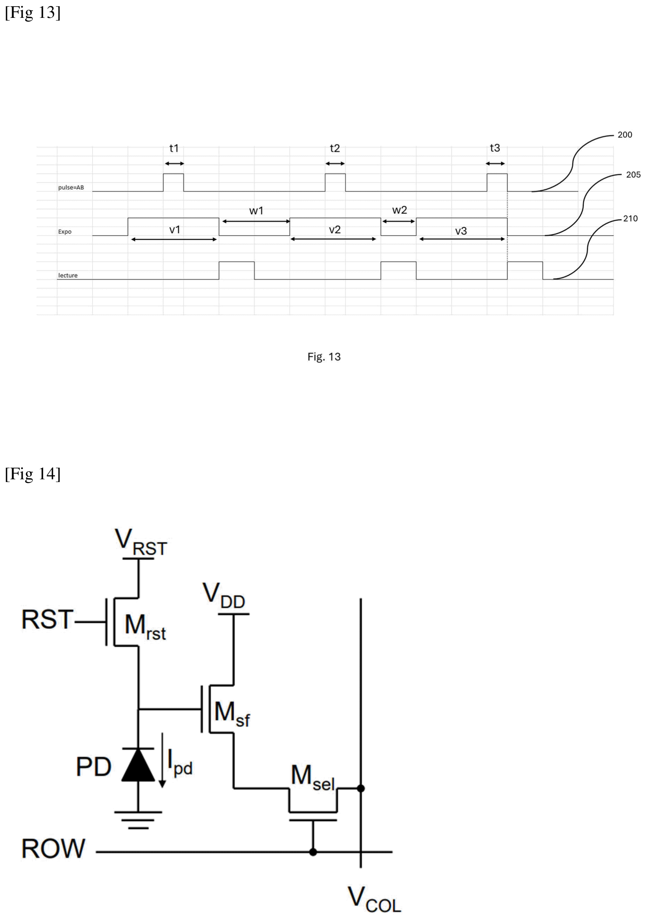

Sur la figure 13 est représenté un chronogramme illustrant le fonctionnement d'un capteur avec la détection de l'impulsion sur le signal de sortie d'une structure anti-blooming. Les échelles de temps des différents signaux ne sont pas nécessairement respectées dans un souci de clarté.

La courbe 200 représente le signal de sortie d'une structure anti-blooming, détectant des impulsions successives d'une durée t1, t2, t3 constante, ayant une certaine fréquence de répétition.

La courbe 205 représente la durée d'exposition du capteur. L'exposition du capteur débute sur le front montant de se termine sur le front descendant. La durée d'exposition v1, v2, v3 mesurée entre le front montant et le front descendant est prédéfinie et constante dans cet exemple. L'intervalle de temps w1 et w2 entre deux expositions consécutives est représenté.

La courbe 210 représente le signal de lecture du pixel qui a lieu à la fin de chaque période d'exposition du capteur.

L'exposition du capteur n'est pas synchronisée en début d'acquisition des images avec l'impulsion laser, car la fréquence de celui-ci n'a pas encore été déterminée par le capteur. La fréquence des impulsions est déterminée en mesurant l'intervalle de temps entre les impulsions t1 et t2. La connaissance de cette fréquence permet d'anticiper le moment de survenance des impulsions suivantes.

La fréquence d'impulsions laser étant ainsi déterminée, le délai initial w1 entre deux expositions est réduit à w2 pour synchroniser la fin de l'impulsion d'une durée t3 avec la fin de l'exposition de durée v3. La synchronisation de la fin de l'exposition avec l'impulsion peut avoir lieu sur le front montant ou descendant de celle-ci, indifféremment, compte-tenu des ordres de grandeurs entre les durées d'impulsion et les durées d'exposition.

De cette façon, des impulsions initiales sont utilisées pour déterminer la fréquence des impulsions et permettre la synchronisation de la fin de l'exposition intervient avec les impulsions suivantes.

### Exemple

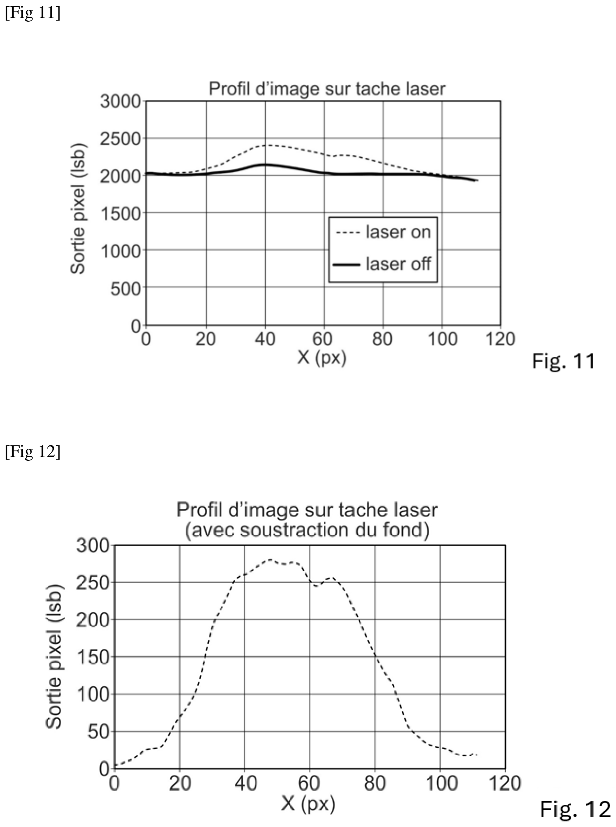

On a représenté sur la figure 11 un exemple de réponse d'un capteur selon l'invention à une scène éclairée avec un illuminateur laser en plein jour.

La figure 12 illustre la soustraction au signal global du signal correspondant au flux lumineux constant de la scène ; on voit l'image de tache, et notamment la distribution spatiale de l'intensité lumineuse de la tâche, avec une intensité plus forte au centre de celle-ci.

L'invention n'est pas limitée aux modes de réalisation qui viennent d'être décrits.

Le dispositif 1 peut comporter des sous-ensembles de pixels agencés de telle sorte que le traitement du signal de sortie des sous-ensembles de drains anti-blooming n'est pas effectué à l'emplacement prévu pour des pixels du sous-ensemble de pixels.

Le dispositif 1 peut comporter des sous-ensembles de drains anti-blooming dont au moins une partie du signal de sortie est traité à l'emplacement prévu pour un pixel et des sous-ensembles de drains anti-blooming dont le signal n'est pas traité à l'emplacement d'un pixel. Le signal de sortie des sous-ensembles peut être collecté au niveau de l'emplacement prévu pour un pixel. Le signal collecté peut être préfiltré à l'emplacement prévu pour un pixel. L'analyse du signal préfiltré peut aussi être effectuée hors de l'emplacement prévu pour un pixel.

Le signal de sortie de chaque sous-ensemble de drains anti-blooming peut être traité indépendamment, tout comme les images détectées par chaque sous-ensemble de pixels.

Les pixels peuvent être de type conventionnel opérant non pas en mode photovoltaïque mais en mode photoconducteur. Dans ce cas, l'invention présente l'avantage de permettre d'utiliser les diodes de détection intégrées au capteur et ne jouant pas le rôle de pixels sur l'image pour détecter l'impulsion lumineuse liée à la tâche laser, ce qui évite de faire reposer cette détection uniquement sur un traitement de l'image provenant des pixels. Ces diodes occupent par exemple la même disposition sur l'image que celles de la structure anti-blooming précédemment décrite, mais peuvent en variante présenter des formes et dispositions autres. Ainsi, dans un exemple, les diodes de détection se substituent à celles référencées 60 de la figure 2, en conservant la même disposition relativement aux pixels, lesquels fonctionnent alors en mode photoconducteur, et dans un autre exemple se subsituent aux drains anti-blooming de la figure 4.

A titre d'exemple, on a représenté à la figure 14 un exemple d'un tel pixel, largement connu en tant que tel, à trois transistors, dit pixel « 3T ».

La photodiode (PD) est polarisée en inverse et se comporte comme une capacité, sa tension diminuant proportionnellement au photocourant. Mᵣₛₜ est un interrupteur de reset, dont la fonction est de précharger la photodiode à une tension de départ V_{RST}, avant que l'exposition ne commence.

M_{sf} sert d'amplificateur à drain commun, et sa source de courant est partagée entre les pixels d'une colonne. Mₛₑₗ est un interrupteur de sélection de ligne. L'invention n'est pas limitée à un capteur opérant exclusivement en mode photovoltaïque ou en mode photoconducteur, et s'applique également au cas où le capteur opère sélectivement dans l'un des deux modes.

## Revendications

1. Procédé de détection d'une tache lumineuse (T) formée par une impulsion laser délivrée par une source laser (10) sur une surface cible (S), la surface cible étant située dans un environnement délivrant un flux lumineux sensiblement statique, ce procédé comportant :
- l'observation de la surface par au moins un capteur (30) à matrice de pixels,
- la détection de l'impulsion sur un signal de sortie d'au moins une structure anti-blooming (60) du capteur configurée pour prévenir l'effet blooming qui se produit lorsque des charges électriques excessives s'accumulent dans un pixel du capteur en raison d'une forte lumière et débordent dans les pixels adjacents du capteur lorsque le capteur opère en mode photovoltaïque ou, lorsque le capteur opère en mode photoconducteur, sur un signal de sortie d'au moins une diode de détection intégrée au capteur et autre qu'une diode correspondant à un pixel de l'image du capteur.

2. Procédé selon la revendication 1, les pixels opérant en mode photovoltaïque.

3. Procédé selon la revendication 1 ou 2, comportant la synchronisation de la fin de l'exposition, à un retard près, avec l'impulsion laser, cette synchronisation conduisant dans le cas de pixels opérant en mode photovoltaïque à une réponse du capteur sensiblement linéaire à l'impulsion et logarithmique vis-à-vis du flux lumineux sensiblement statique, le retard de la fin de l'exposition avec l'impulsion laser étant de préférence inférieur ou égal à 10 µs, la fréquence des impulsions étant de préférence déterminée sur le signal de sortie entre deux impulsions détectées, le début de l'exposition du capteur étant de préférence anticipé en fonction de la fréquence des impulsions déterminée sur le signal de sortie.

4. Procédé selon l'une quelconque des revendications précédentes, la structure anti-blooming (60) comportant au moins un drain anti-blooming, notamment une diode anti-blooming (68), la structure anti-blooming (60) utilisée pour la détection de l'impulsion comportant de préférence plusieurs drains anti-blooming connectés en parallèle.

5. Procédé selon l'une quelconque des revendications précédentes, la structure anti-blooming (60) utilisée pour la détection comportant un ou plusieurs sous-ensembles de drains d'anti-blooming (40a, 40b, 40c) disposés autour d'un ou plusieurs sous-ensembles respectifs de pixels de la matrice, les sous-ensembles de drains anti-blooming (40a, 40b, 40c) reliés ensemble comportant de préférence des drains anti-blooming disposés selon des polygones, notamment des carrés, autour de sous-ensembles correspondants de la matrice de pixels.

6. Procédé selon l'une quelconque des revendications précédentes, le signal de sortie de la ou de chaque structure d'anti-blooming (60) utilisée pour la détection de l'impulsion lorsque le capteur opère en mode photovoltaïque ou de ladite au moins une diode de détection intégrée au capteur lorsque le capteur opère en mode photoconducteur, étant filtré en fréquence pour détecter la présence d'impulsions d'une fréquence d'intérêt.

7. Procédé selon l'une quelconque des revendications précédentes, le signal de sortie de la ou de chaque structure d'anti-blooming (60) utilisée pour la détection de l'impulsion lorsque le capteur opère en mode photovoltaïque ou de ladite au moins une diode de détection intégrée au capteur lorsque le capteur opère en mode photoconducteur, étant filtré pour diminuer le bruit.

8. Procédé selon l'une quelconque des revendications précédentes, comportant au moins deux structures d'anti-blooming (60) utilisées respectivement pour la détection d'impulsions de fréquences différentes lorsque le capteur opère en mode photovoltaïque ou, au moins deux diodes de détection intégrées au capteur lorsque le capteur opère en mode photoconducteur, les signaux en sortie de ces structures d'anti-blooming ou de ces diodes étant de préférence filtrés en fréquence pour détecter le front montant d'impulsions auxdites fréquences.

9. Procédé selon l'une quelconque des revendications précédentes, au moins une partie du traitement du signal de sortie étant effectuée au sein du capteur, au moins une partie du traitement étant de préférence effectuée localement sur la matrice à l'emplacement (55) prévu pour au moins un pixel de la matrice.

10. Procédé selon les revendications 5 à 9, le traitement du signal de sortie pour chaque sous-ensemble (40a, 40b, 40c) étant effectué localement à l'emplacement prévu pour au moins un pixel du sous-ensemble (55a, 55b, 55c).

11. Procédé selon l'une quelconque des revendications 1 à 8, le signal de sortie étant délivré localement sur la matrice à l'emplacement prévu pour au moins un pixel de la matrice.

12. Système de détection d'une tâche lumineuse formée par une impulsion laser d'une source laser (10) sur une scène délivrant un flux sensiblement statique, comportant
- au moins un capteur (30) à matrice de pixels,
- au moins une structure anti-blooming (60) lorsque le capteur opère en mode photovoltaïque ou, lorsque le capteur opère en mode photoconducteur, au moins une diode intégrée au capteur et autre qu'une diode correspondant à un pixel de l'image,
- au moins un circuit de détection de l'impulsion sur un signal de sortie de la structure anti-blooming du capteur lorsque le capteur opère en mode photovoltaïque ou lorsque le capteur opère en mode photoconducteur sur un signal de sortie de ladite au moins diode de détection intégrée, et/ou un circuit de traitement pour délivrer une information relative à la fréquence de l'impulsions laser.

13. Système selon la revendication précédente, les pixels opérant en mode photovoltaïque.

14. Système selon l'une des revendications 12 et 13, comportant un circuit de synchronisation (21) de la fin de l'exposition du capteur, à un retard près, avec l'impulsion laser, sur la base dudit signal, cette synchronisation conduisant dans le cas de pixels opérant en mode photovoltaïque à une réponse du capteur sensiblement linéaire à l'impulsion et logarithmique vis-à-vis du flux lumineux sensiblement statique.

15. Système selon l'une des revendications 12 à 14, comportant un filtre pour diminuer le bruit du signal de sortie de la structure anti-blooming ou de ladite au moins une diode de détection intégrée au capteur et/ou comportant un filtre en fréquence configuré pour détecter la présence d'impulsions à une fréquence d'intérêt provenant du signal de sortie de la structure anti-blooming ou de ladite au moins une diode de détection intégrée au capteur.
